# EUROPEAN PATENT APPLICATION

(11) **EP 4 750 263 A1**
(43) Date of publication of application: **27.05.2026**
(21) Application number: 24214530.8
(22) Date of filing: 21.11.2024
(51) Int. Cl.: H10D 89/60, H01L 23/60

(54) **SEMICONDUCTOR DEVICE INCLUDING FIRST AND SECOND SEMICONDUCTOR SUBSTRATE PORTIONS**

(71) Applicant: Infineon Technologies AG, 85579 Neubiberg (DE)
(72) Inventor: SCHMENN, Andre, 83679 Sachsenkam (DE); SOJKA, Damian, 93057 Regensburg (DE); ROPOHL, Jan, 93049 Regensburg (DE); KINDL, Benedikt, 92421 Schwandorf (DE)
(74) Representative: Müller Hoffmann & Partner

(57) **Abstract**

A semiconductor device (100) is proposed. The semiconductor device includes a semiconductor substrate (102) including at least a first semiconductor substrate portion (1021) and a second semiconductor substrate portion (1022) separated from one another by a first part (1041) of an intermediate dielectric structure (104) along a first lateral direction (x1). The semiconductor device (100) further includes a patterned first metal layer (106) over a first surface (1081) of the semiconductor substrate (102), wherein a first part (1061) of the patterned first metal layer (106) electrically connects the first and second semiconductor substrate portions (1021, 1022) at the first surface (1081). Each of the first and second semiconductor substrate portions (1021, 1022) includes a main portion (1023) adjoining the first surface (1081) and an auxiliary portion (1024) adjoining a second surface (1082) opposite to the first surface (1081), and, with respect to each of the first and second semiconductor substrate portions (1021, 1022), a width (w12, w22) of the auxiliary portion (1024) along the first lateral direction (x1) is larger than a width (w11, w21) of the main portion (1023) along the first lateral direction (x1).

## Description

### TECHNICAL FIELD

The present disclosure relates to a semiconductor device, in particular to semiconductor device including first and second semiconductor substrate portions.

### BACKGROUND

Electrostatic discharges (ESD) may adversely affect, for example even melt or destroy, tiny structures in integrated circuits (ICs). Such electrostatic discharges may for example occur when a human touches terminals like pads of the integrated circuit. To prevent or at least mitigate such problems, input and output pads of integrated circuits are typically connected to ESD protection circuits, which are designed to shunt electrostatic discharges to ground or another potential.

In various applications, development of more powerful electric circuits, minimization of structures, reduction of gate oxide thickness and the like led to increasing requirements to such electrostatic discharge protection circuits. One example for such applications are state of the art interfaces like universal serial bus (USB) 3.1 or 4 interfaces, high definition multimedia interfaces (HDMI) or thunderbolt interfaces. For providing a good protection in case of an electrostatic discharge, the intrinsic resistance of the ESD protection circuit when an electrostatic discharge is to be shunted, for example to ground, has to be minimized.

On the other hand, during normal operation, an electrostatic discharge circuit may act as a parasitic capacitance to a device where it is incorporated. In particular for higher frequency applications like the above-mentioned interfaces, minimization of such capacitances provided by the electrostatic discharge protection circuit is desirable to maintain signal integrity of signals transmitted over the interface. Similar considerations may apply to other input/output pads of circuits and devices other than interfaces.

Thus, ESD protection devices as described above but also other semiconductor devices face increasingly challenging requirements with respect to, for example, electrical specifications such as capacitance, RF coupling, intrinsic resistance, cost and development timeline. Improved semiconductor devices are needed to meet these requirements.

### SUMMARY

An example of the present disclosure relates to a semiconductor device. The semiconductor device includes a semiconductor substrate including at least a first semiconductor substrate portion and a second semiconductor substrate portion separated from one another by a first part of an intermediate dielectric structure along a first lateral direction. The semiconductor device further includes a patterned first metal layer over a first surface of the semiconductor substrate. A first part of the patterned first metal layer electrically connects the first and second semiconductor substrate portions at the first surface. Each of the first and second semiconductor substrate portions includes a main portion adjoining the first surface and an auxiliary portion adjoining a second surface opposite to the first surface. With respect to each of the first and second semiconductor substrate portions, a width of the auxiliary portion along the first lateral direction is larger than a width of the main portion along the first lateral direction.

Another example of the present disclosure relates to a method of manufacturing a semiconductor device. The method includes forming a semiconductor substrate including at least a first semiconductor substrate portion and a second semiconductor substrate portion separated from one another by a first part of an intermediate dielectric structure along a first lateral direction. The method further includes forming a patterned first metal layer over a first surface of the semiconductor substrate. A first part of the patterned first metal layer electrically connects the first and second semiconductor substrate portions at the first surface. Each of the first and second semiconductor substrate portions includes a main portion adjoining the first surface and an auxiliary portion adjoining a second surface opposite to the first surface. With respect to each of the first and second semiconductor substrate portions, a width of the auxiliary portion along the first lateral direction is larger than a of the main portion along the first lateral direction.

Those skilled in the art will recognize additional features and advantages upon reading the following detailed description, and upon viewing the accompanying drawings.

### BRIEF DESCRIPTION OF THE DRAWINGS

The accompanying drawings are included to provide a further understanding of the embodiments and are incorporated in and constitute a part of this specification. The drawings illustrate examples of semiconductor devices and together with the description serve to explain principles of the examples. Further examples are described in the following detailed description and the claims.
Fig. 1 is a schematic cross-sectional view for illustrating a configuration example of a semiconductor device.
Fig. 2 is an exemplary process illustration of manufacturing a semiconductor device.
Figs. 3A to 3T are cross-sectional views for illustrating process features of manufacturing a configuration example of a semiconductor device.

### DETAILED DESCRIPTION

In the following detailed description, reference is made to the accompanying drawings, which form a part hereof and in which are shown by way of illustrations specific examples in which semiconductor devices may be formed. It is to be understood that other examples may be utilized and structural or logical changes may be made without departing from the scope of the present disclosure. For example, features illustrated or described for one example can be used on or in conjunction with other examples to yield yet a further example. It is intended that the present disclosure includes such modifications and variations. The examples are described using specific language, which should not be construed as limiting the scope of the appending claims. The drawings are not scaled and are for illustrative purposes only. Corresponding elements are designated by the same reference signs in the different drawings if not stated otherwise.

The terms "having", "containing", "including", "comprising" and the like are open, and the terms indicate the presence of stated structures, elements or features but do not preclude the presence of additional elements or features. The articles "a", "an" and "the" are intended to include the plural as well as the singular, unless the context clearly indicates otherwise.

The term "electrically connected" may describe a permanent low-resistive connection between electrically connected elements, for example a direct contact between the concerned elements or a low-resistive connection via a metal and/or heavily doped semiconductor material. The term "electrically coupled" may include that one or more intervening element(s) adapted for signal and/or power transmission may be connected between the electrically coupled elements, for example, elements that are controllable to temporarily provide a low-resistive connection in a first state and a high-resistive electric decoupling in a second state. An ohmic contact may be a non-rectifying electrical junction.

Ranges given for physical dimensions include the boundary values. For example, a range for a parameter y from a to b reads as a ≤ y ≤ b. The same holds for ranges with one boundary value like "at most" and "at least".

The terms "on" and "over" are not to be construed as meaning only "directly on" and "directly over". Rather, if one element is positioned "on" or "over" another element (e.g., a layer is "on" or "over" another layer or "on" or "over" a substrate), a further component (e.g., a further layer) may be positioned between the two elements (e.g., a further layer may be positioned between a layer and a substrate if the layer is "on" or "over" said substrate).

An example of the present disclosure relates to a semiconductor device. The semiconductor device includes a semiconductor substrate including at least a first semiconductor substrate portion and a second semiconductor substrate portion separated from one another by a first part of an intermediate dielectric structure along a first lateral direction. The semiconductor device further includes a patterned first metal layer over a first surface of the semiconductor substrate. A first part of the patterned first metal layer electrically connects the first and second semiconductor substrate portions at the first surface. Each of the first and second semiconductor substrate portions includes a main portion adjoining the first surface and an auxiliary portion adjoining a second surface opposite to the first surface. With respect to each of the first and second semiconductor substrate portions, a width of the auxiliary portion along the first lateral direction is larger than a width of the main portion along the first lateral direction.

For example, the semiconductor substrate may include or consist of a semiconductor material from the group IV elemental semiconductors, IV-IV compound semiconductor material, III-V compound semiconductor material, or II-VI compound semiconductor material. Examples of semiconductor materials from the group IV elemental semiconductors include, inter alia, silicon (Si) and germanium (Ge). Examples of IV-IV compound semiconductor materials include, inter alia, silicon carbide (SiC) and silicon germanium (SiGe). Examples of III-V compound semiconductor material include, inter alia, gallium arsenide (GaAs), gallium nitride (GaN), gallium phosphide (GaP), indium phosphide (InP), indium gallium nitride (InGaN) and indium gallium arsenide (InGaAs). Examples of II-VI compound semiconductor materials include, inter alia, cadmium telluride (CdTe), mercury-cadmium-telluride (CdHgTe), and cadmium magnesium telluride (CdMgTe). For example, the semiconductor substrate may be formed of a semiconductor base substrate, e.g. wafer, having none, one or even more semiconductor layers such as epitaxial semiconductor layers on the semiconductor base substrate. The semiconductor substrate may be a Czochralski (CZ), e.g. a magnetic Czochralski, MCZ, or a float zone (FZ), or an epitaxially deposited silicon semiconductor substrate.

For example, in the main portion of each of the first and second semiconductor substrate portions, one or more doped regions may be present depending on the target functionality of the device integrated in the respective main portion, e.g. diode and/or transistor and/or thyristor. Also the auxiliary portion of each of the first and second semiconductor substrate portions may contribute to the target functionality of the device integrated in the respective main portion. For example, a doped region in the auxiliary portion of each of the first and second semiconductor substrate portions may be configured as a highly doped contact region for enabling an ohmic contact to a load electrode, e.g. a metal, formed on the auxiliary portion.

The patterned first metal layer may be part of a wiring area over the first surface semiconductor substrate. The wiring area may include one or more than one, e.g. two, three, four or even more wiring levels. Each wiring level may be formed by a single one or a stack of conductive layers, e.g. metal layer(s) or highly doped semiconductor layers such as highly doped polycrystalline silicon. For example, the wiring levels may include at least one of Cu, Au, AlCu, Ag, or alloys thereof. The wiring levels may be lithographically patterned, for example. The wiring area may also include a higher resistive level for resistor formation, e.g. a highly resistive polycrystalline layer. Between stacked wiring levels, an interlayer dielectric structure may be arranged. Contact plug(s) or contact line(s) may be formed in openings in the interlayer dielectric structure to electrically connect parts, e.g. metal lines or contact areas, of different wiring levels to one another.

The first surface may be a front surface or a top surface of the semiconductor substrate, and the second surface may be a back surface or a rear surface of the semiconductor substrate, for example.

Depending on the device circuits included in the semiconductor substrate of the semiconductor device, an appripriate number of semiconductor substrate portions laterally separated by the intermediate dielectric structure may be chosen and electrically interconnected by a wiring area including the patterned first metal layer. For example, apart from the first and second semiconductor substrate portions, a third, a fourth, a fifth, a sixth, a seventh or even more semiconductor substrate portions may be provided, e.g. for providing multi-serial diode, anti-parallel SCRs (silicon controlled rectifiers), or stacked devices.

The laterally separated first and second semiconductor substrate portions, each having a main and auxiliary portion, allow for a number of technical benefits. The first surface accessing the main portion and the second surface accessing the auxiliary portion of the laterally separated first and second semiconductor substrate portions enable device formation from the first surface, e.g. front side, and from the second surface, e.g. back side, on ultra-thin semiconductor substrates. An independent metal interconnection by respective wiring areas over the first and second surface enables an optimized flexibility for device circuits, e.g. serial, anti-parallel, or stacked. A thickness of the main and auxiliary portion may be optimized for reducing the device resistance, for example. Furthermore, the intermediate dielectric structure between the laterally separated substrate portion may allow for a reduced coupling and for device flexibility in the semiconductor substrate portions due to little topography of the device arrangement.

For example, with respect to each of the first and second semiconductor substrate portions, a thickness of the main portion along a vertical direction may be larger than a thickness of the auxiliary portion along the vertical direction. For example, the main portion may include a pn junction and a vertical extent of the main portion may depend on a voltage blocking capability of the pn junction. The auxiliary portion may define a contact portion for enabling an ohmic contact at the second surface of the semiconductor substrate.

For example, the thickness of the main portion of the first semiconductor substrate portion equals the thickness of the main portion of the second semiconductor substrate portion. The thickness of the auxiliary portion of the first semiconductor substrate portion equals the thickness of the auxiliary portion of the second semiconductor substrate portion. The first and second semiconductor substrate portions may be separate portions of one and the same semiconductor substrate, e.g. wafer. The first and second semiconductor substrate portions may be separated from one another by processing the semiconductor substrate at the first and second side, e.g. front and rear or back side, by etching and/or abrasive machining such as grinding.

For example, the thickness of the auxiliary portion may range from 500 nm to 10 µm.

For example, the semiconductor device may have a lateral distance between the main portion of the first and second semiconductor substrate portions in the range from 5 µm to 500 µm.

For example, the auxiliary portion of the first semiconductor substrate portion may include a doped semiconductor contact region having a doping concentration larger than 1 × 10¹⁹ cm⁻³, or larger than 5 × 10¹⁹ cm⁻³. The semiconductor device may further include a patterned second metal layer over a second surface of the semiconductor substrate. A first part of the patterned second metal layer may electrically connect the doped semiconductor contact region to a first contact pad. For example, the first contact pad may be laterally spaced from the first semiconductor substrate portion. In some other examples, a vertical projection of the first semiconductor substrate portion onto the first surface of the semiconductor substrate may partly or fully overlap with a vertical projection of the first contact pad onto the first surface of the semiconductor substrate.

For example, the semiconductor device may further include a passivation layer extending from over the second surface of the first semiconductor substrate portion to over the second surface of the second semiconductor substrate portion.

For example, the semiconductor device may further include a carrier mounted on the semiconductor substrate at a side of the first surface of the semiconductor substrate. For example, the carrier may be a semiconductor wafer or substrate, e.g. low doped silicon, a glass or mold carrier. A material of the carrier may be chosen not only in view of mechanical support for the semiconductor substrate but also in view of a reduced coupling or capacitance between the semiconductor substrate portions, for example.

For example, wherein the semiconductor device may be an ESD protection device in a chip package including a first ESD protection sub-device in the first semiconductor substrate portion and a second ESD protection sub-device in the second semiconductor substrate portion, and, optionally, further ESD sub-devices in further semiconductor substrate portions. ESD protection devices are used to protect electronic circuit blocks of an integrated circuit from electrostatic discharge pulses or other current pulses that can occur during the manufacture of the integrated circuit, e.g. back-end processing, or during its operation. Examples of such pulses are HBM (HBM: Human Body Model) pulses according to DIN IEC 60749-26, MM (MM: Machine Model) pulses according to DIN IEC 60749-27, or CDM (CDM: Charged Device Model) pulses according to DIN IEC 60749-28, or pulses defined in Electrostatic discharge immunity test according to DIN IEC 61000-4-2. When omitting ESD protection devices, there is a risk of destruction of useful components of the circuit blocks to be protected, e.g. due to current or voltage overload, which can lead, inter alia, to short circuits, an increase in leakage currents or defective gate oxides. This can result in a loss of functionality of the integrated circuit.

Details with respect to structure, or function, or technical benefit of features described above with respect to a semiconductor device likewise apply to the exemplary methods described herein. Processing the semiconductor substrate may comprise one or more optional additional features corresponding to one or more aspects mentioned in connection with the proposed concept or one or more examples described above or below.

A method of manufacturing a semiconductor device includes forming a semiconductor substrate including at least a first semiconductor substrate portion and a second semiconductor substrate portion separated from one another by a first part of an intermediate dielectric structure along a first lateral direction. The method further includes forming a patterned first metal layer over a first surface of the semiconductor substrate. A first part of the patterned first metal layer electrically connects the first and second semiconductor substrate portions at the first surface. Each of the first and second semiconductor substrate portions includes a main portion adjoining the first surface and an auxiliary portion adjoining a second surface opposite to the first surface. With respect to each of the first and second semiconductor substrate portion, a width of the auxiliary portion along the first lateral direction is larger than a width of the main portion along the first lateral direction.

For example, forming the semiconductor substrate may include processing the semiconductor substrate at the first surface by at least one doping process. Thereafter, a first masked etch process at the first surface of the semiconductor substrate may follow for defining the main portion of the first semiconductor substrate portion and of the second semiconductor substrate portion. For example, the at least one doping process may include one or more ion implantation processes for defining a source and/or drain region, an anode and/or cathode region, or an emitter and/or base and/or collector region.

For example, the method may further include, after conducting the first masked etch process, mounting a carrier on the semiconductor substrate at a side of the first surface of the semiconductor substrate. The method may further include reducing a thickness of the semiconductor substrate by machining and/or etching processes. The method may further include processing the semiconductor substrate at the second surface by at least one doping process. The method may further include conducting a second masked etch process at the second surface of the semiconductor substrate for defining the auxiliary portion of the first semiconductor substrate portion and of the second semiconductor substrate portion.

For example, processing the semiconductor substrate at the second surface may include forming a doped semiconductor contact region having a doping concentration larger than 5 × 10¹⁹ cm⁻³ in the auxiliary portion of the first semiconductor substrate portion. Dopants of the semiconductor contact region may be electrically activated by a laser thermal anneal, LTA process. In some other examples, the semiconductor contact region as part of the auxiliary portion may be formed before processing the semiconductor substrate at the first surface by at least one doping process. For example, the auxiliary portion and the main portion may be formed based on two or more semiconductor layers formed on a base substrate. The semiconductor layer of the auxiliary portion may have a larger doping concentration, e.g. formed by in-situ doping and/or ion implantation, than the semiconductor layer of the main portion. The first masked etch process at the first surface of the semiconductor substrate for defining the main portion of the first semiconductor substrate portion and of the second semiconductor substrate portion may be carried out by an etch process that stops when reaching the semiconductor layer of the auxiliary portion that has a larger doping concentration than the semiconductor layer of the main portion.

For example, the method may further include forming a patterned second metal layer over the second surface of the semiconductor substrate. The method may further include forming a passivation layer on the patterned second metal layer and on the intermediate dielectric structure. The passivation layer may extend from over the second surface of the first semiconductor substrate portion to over the second surface of the second semiconductor substrate portion.

The description and drawings merely illustrate the principles of the disclosure. Furthermore, all examples recited herein are principally intended expressly to be only for illustrative purposes to aid the reader in understanding the principles of the disclosure and the concepts contributed by the inventor(s) to furthering the art. All statements herein reciting principles, aspects, and examples of the disclosure, as well as specific examples thereof, are intended to encompass equivalents thereof.

The examples and features described above and below may be combined. Functional and structural details (e.g. materials, dimensions) described with respect to the examples above shall likewise apply to the examples illustrated in the figures and described further below.

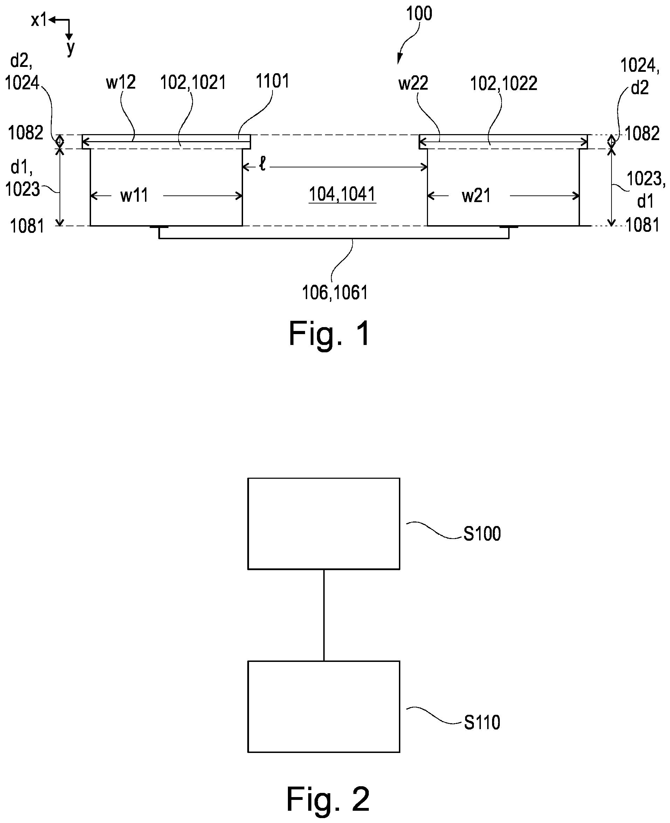

Fig. 1 illustrates a configuration example of a semiconductor device 100. The semiconductor device 100 includes a semiconductor substrate 102, e.g. a semiconductor base substrate having one, two or more semiconductor layers formed thereon, or a thinned semiconductor substrate where the semiconductor base substrate has been removed fully or partly and the semiconductor layer(s) remain. The semiconductor substrate 102 includes at least a first semiconductor substrate portion 1021 and a second semiconductor substrate portion 1022. The substrate potions 1021, 1022 are laterally, e.g. along a first lateral direction x1, spaced from one another by a first part 1041 of an intermediate dielectric structure 104. The first and second substrate portions 1021, 1022 are processed from a single semiconductor base substrate, e.g. wafer.

A patterned first metal layer 106 is arranged over a first surface 1081 of the semiconductor substrate 102. A first part 1061 of the patterned first metal layer 106 electrically connects the first and second semiconductor substrate portions 1021, 1022 at the first surface 1081.

Each of the first and second semiconductor substrate portions 1021, 1022 includes a main portion 1023 adjoining the first surface 1081 and an auxiliary portion 1024 adjoining a second surface 1082 opposite to the first surface 1081. For each of the first and second semiconductor substrate portions 1021, 1022, a width w12, w22 of the auxiliary portion 1024 along the first lateral direction x1 is larger than a width w11, w21 of the main portion 1023 along the first lateral direction x1.

For each of the first and second semiconductor substrate portions 1021, 1022, a thickness d1 of the main portion 1023 along a vertical direction y is larger than a thickness d2 of the auxiliary portion 1024 along the vertical direction y.

The thickness d1 of the main portion 1023 of the first semiconductor substrate portion 1021 equals the thickness of the main portion 1023 of the second semiconductor substrate portion 1022. The thickness d2 of the auxiliary portion 1024 of the first semiconductor substrate portion 1021 equals the thickness of the auxiliary portion 1024 of the second semiconductor substrate portion 1022. This may be achieved by concurrently processing the semiconductor substrate 102 including the first and second substrate portions, e.g. concurrently reducing a substrate thickness by etching and/or machining processes.

More details and aspects are mentioned in connection with the examples described above or below. Processing a semiconductor substrate, e.g. a wafer, may comprise one or more optional additional features corresponding to one or more aspects mentioned in connection with the proposed concept or one or more examples described above or below. It is to be understood that the disclosure of multiple acts, processes, operations, steps or functions disclosed in the specification or claims may not be construed as to be within the specific order, unless explicitly or implicitly stated otherwise, e.g. by expressions like "thereafter", for instance for technical reasons. Therefore, the disclosure of multiple acts or functions will not limit these to a particular order unless such acts or functions are not interchangeable for technical reasons. Furthermore, in some examples a single act, function, process, operation or step may include or may be broken into multiple sub-acts, -functions, -processes, -operations or-steps, respectively. Such sub acts may be included and part of the disclosure of this single act unless explicitly excluded.

The schematic cross-sectional view of Fig. 2 illustrates process features of an exemplary method of manufacturing a semiconductor device 100 based on the method of Fig. 1
Process feature S100 includes forming a semiconductor substrate including at least a first semiconductor substrate portion and a second semiconductor substrate portion separated from one another by a first part of an intermediate dielectric structure along a first lateral direction.

Process feature S110 includes forming a patterned first metal layer over a first surface of the semiconductor substrate, wherein a first part of the patterned first metal layer electrically connects the first and second semiconductor substrate portions at the first surface. Each of the first and second semiconductor substrate portions includes a main portion adjoining the first surface and an auxiliary portion adjoining a second surface opposite to the first surface. With respect to each of the first and second semiconductor substrate portion. A width of the auxiliary portion along the first lateral direction is larger than a width of the main portion along the first lateral direction.

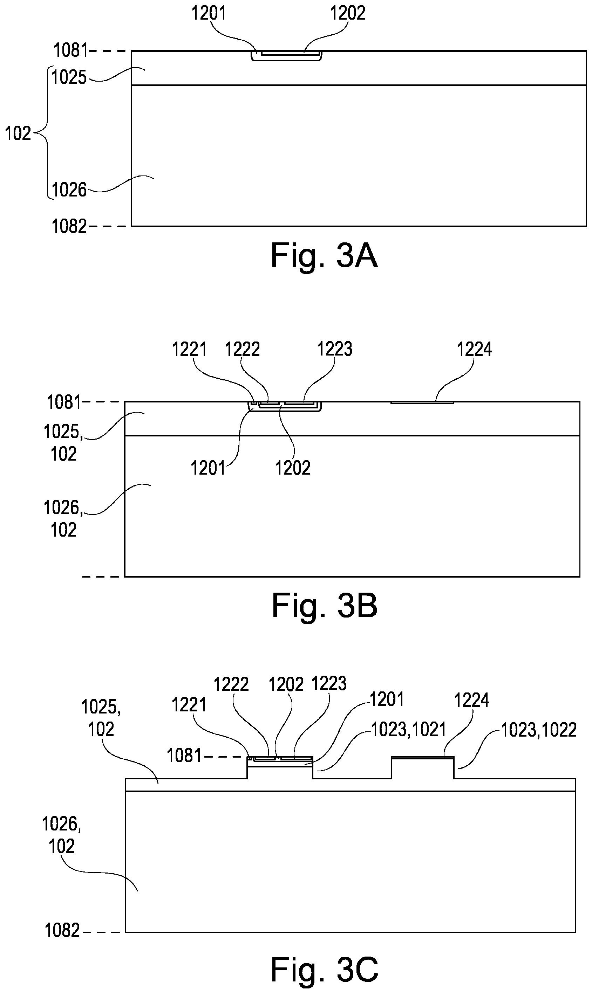

The schematic cross-sectional views of Figs. 3A to 3T illustrate process features of forming a configuration example of a semiconductor device 100.

Referring to Fig. 3A, a semiconductor layer 1025 is formed on a semiconductor base substrate 1026. The semiconductor layer may be formed by a single layer or may include sub-layers, e.g. a single n-doped layer or an n⁺-doped first sub-layer having a higher doping concentration and smaller thickness than an n-doped second sub-layer on the first sub-layer. The semiconductor layer may be formed by a layer deposition or growth process, e.g. chemical vapor deposition (CVD) or epitaxial growth. The semiconductor layer 1025 and the semiconductor base substrate 1026 constitute a semiconductor substrate 102 having a first surface 1081 and a second surface 1082 opposite to the first surface 1081. Doped regions 1201, 1202, e.g. an n-doped well 1201 and a p-doped well 1202, are formed in the semiconductor substrate 102 at the first surface 1081, e.g. by ion implantation and/or diffusion processes.

Referring to Fig. 3B, highly doped contact or injection regions 1221, 1222, 1223, 1224, e.g. n⁺-doped contact or injection regions 1221, 1222, 1223 and a p⁺-doped contact or injection region 1224, are formed in the semiconductor substrate 102 at the first surface 1081, e.g. by ion implantation and/or diffusion processes.

Referring to Fig. 3C, a masked etch process is carried out to the semiconductor substrate 102 at the first surface 1081. Thereby, mesa regions are defined in the semiconductor substrate 102. A first mesa region is a main portion 1023 of a first semiconductor substrate portion 1021, and a second mesa region is a main portion 1023 of a second semiconductor substrate portion 1022.

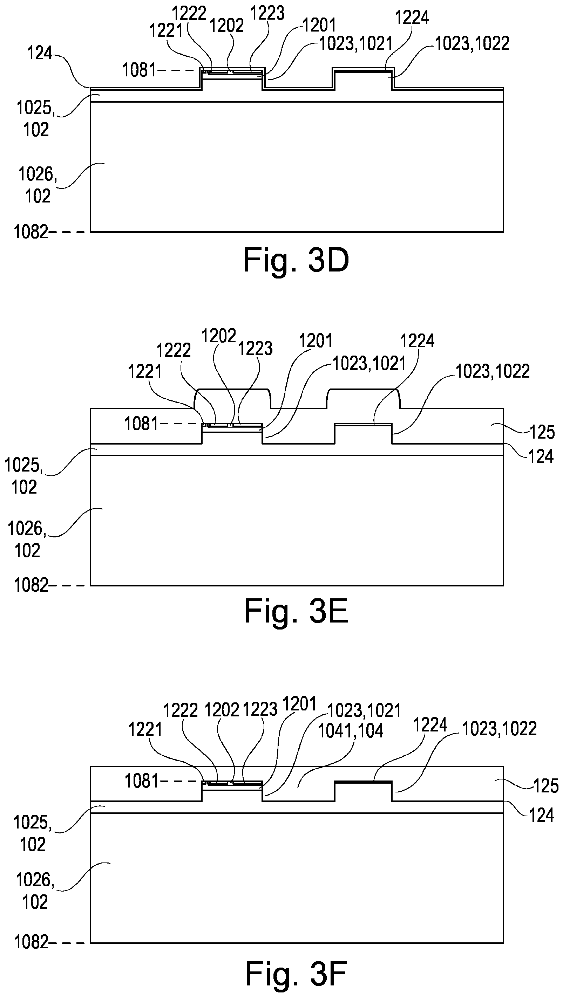

Referring to Fig. 3D, a dielectric layer 124 is formed on the first surface 1081 of the semiconductor substrate 102, e.g. by thermal interface oxidation. The dielectric layer 124 may also be omitted.

Referring to Fig. 3E, a gap between the first and second semiconductor substrate portions 1021, 1022 is filled with a dielectric material 125, e.g. by deposition of a dielectric layer or dielectric layer stack.

Referring to Fig. 3F, the dielectric material 125 is planarized, e.g. by a planarization process such as, for example, chemical mechanical polishing (CMP). The dielectric material 125 separating the second semiconductor substrate portion 1022 from the first semiconductor substrate portion 1021 along the first lateral direction x1 constitutes a first part 1041 of an intermediate dielectric structure 104.

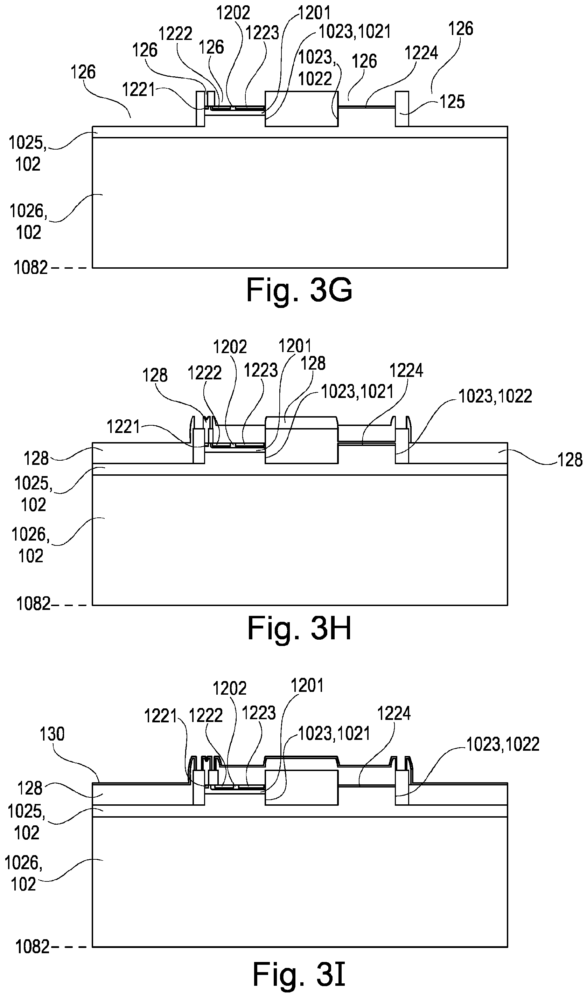

Referring to Fig. 3G, a contact opening 126 is formed in the dielectric material 125 and in the dielectric layer 124, e.g. by a masked etch process.

Referring to Fig. 3H, a contact material 128, e.g. a metal layer or metal layer stack, is formed in the contact opening 126 and on the dielectric material 125 and patterned, e.g. by a masked etch process. Thereby, the highly doped contact or injection region 1224 of the second substrate portion 1022 is electrically connected to the highly doped contact or injection regions 1222, 1223 of the first semiconductor substrate portion 1021.

Referring to Fig. 3I, an adhesion/passivation layer or layer stack 130 is formed on the contact material 128, e.g. by one or more a layer deposition processes.

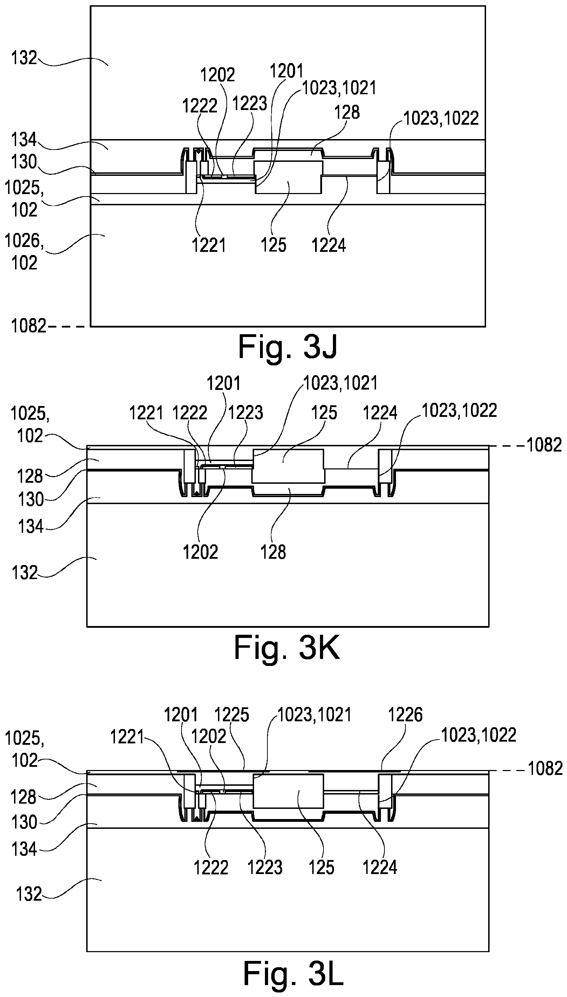

Referring to Fig. 3J, the semiconductor substrate 102 is mounted to a carrier 132 via a side of the first surface 108. An adhesive material 134, e.g. a glue, supports the mechanical stability of the substrate/carrier connection. As an alternative, fusion bonding to the carrier may be used via a planarized surface at a side of the first surface 108, for example.

Referring to Fig. 3K, a thickness of the semiconductor substrate 102 is reduced by machining and/or etching processes. For example, the semiconductor base substrate 1026 and, optionally, part of the semiconductor layer 1025 may be removed.

Referring to Fig. 3L, highly doped contact or injection regions 1225, 1226, e.g. p⁺-doped contact or injection region 1225 and an n⁺-doped contact or injection region 1226, are formed in the semiconductor substrate 102 at the second surface 1082, e.g. by ion implantation and/or diffusion processes.

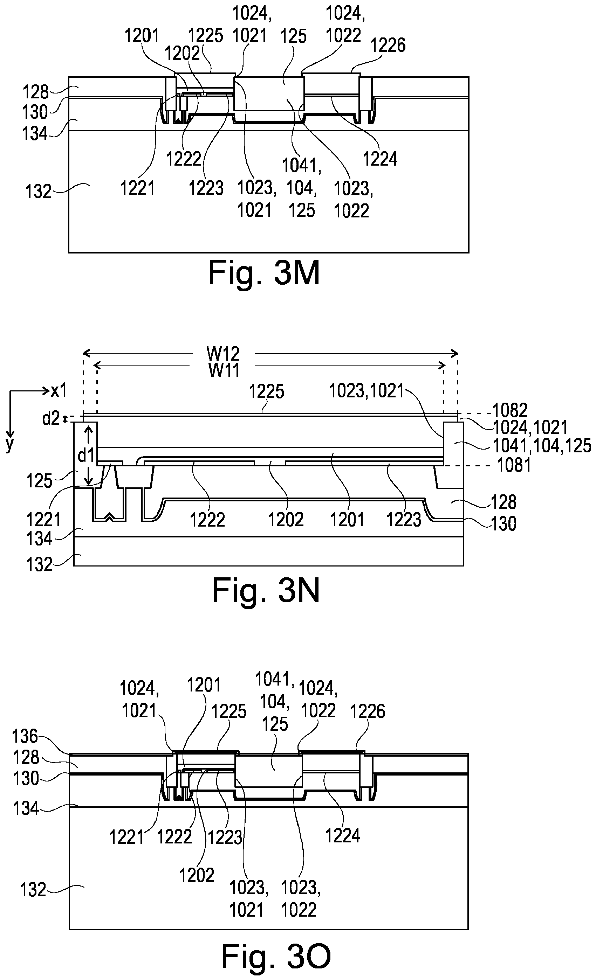

Referring to Fig. 3M, a masked etch process is carried out to the semiconductor substrate 102 at the first surface 1082. For example, the masked etch process may end on the dielectric material 125, thereby laterally separating a first semiconductor substrate portion 1021 from a second semiconductor substrate portion 1022. The mask etched process defines an auxiliary portion 1024 of first semiconductor substrate portion 1021 that is laterally separated from an auxiliary portion 1024 of the second semiconductor substrate portion 1022.

The schematic cross-sectional view of Fig. 3N is an enlarged view of the first semiconductor substrate portion 1021 of the semiconductor substrate 102. The masked etch process results in a double mesa structure for each of the first and second semiconductor substrate portions 1021, 1022. With respect to the first semiconductor substrate portion 1021 illustrated in Fig. 3N, a width w12 of the auxiliary portion 1024 along the first lateral direction x1 is larger than a width w11 of the main portion 1023 along the first lateral direction x1. Similar relations apply to the widths w21, w22 of the main and auxiliary portions 1023, 1024 of the second semiconductor substrate portion 1022 as described with reference to Fig. 1. A thickness d1 of the main portion 1023 of the first semiconductor substrate portion 1021 along the vertical direction y is larger than a thickness d2 of the auxiliary portion 1024 of the first semiconductor substrate portion 1021 along the vertical direction y. Similar relations apply to the thickness of the main and auxiliary portions 1023, 1024 of the second semiconductor substrate portion 1022 as described with reference to Fig. 1. Any number of separate substrate portions may be realized and adapted to the circuity to be realized in separate substrate portions. The formation of semiconductor regions described with reference to Figs. 3A and 3B may be adapted to the specific device elements, e.g. silicon controlled rectifier (SCR), diode, transistor, that are to be formed in the laterally separated substrate portions.

Referring to Fig. 3O, a passivation layer or layer stack 136 is formed on the auxiliary portion 1024 of the first and second semiconductor substrate portions 1021, 1022, on the contact material 128 and on the dielectric material 125.

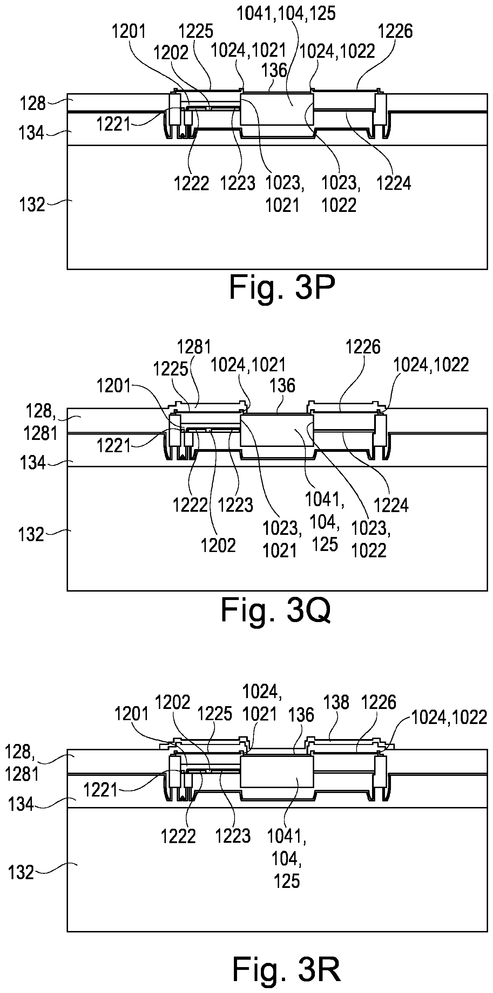

Referring to Fig. 3P, the passivation layer or layer stack 136 is patterned, e.g. by a masked etch process. Thereby a surface portion of the first and second semiconductor substrate portions 1201, 1202 as well as a surface portion of the contact material 128 is exposed.

Referring to Fig. 3Q, a contact material 1281, e.g. a metal layer or metal layer stack, is formed on the exposed surface portions of first and second semiconductor substrate portions 1201, 1202 as well as on the exposed surface portion of the contact material 128. The contact material 1281 is patterned, e.g. by a masked etch process,
Referring to Fig. 3R, a passivation/protection layer or layer stack 138 is formed on the first and second semiconductor substrate portions 1021, 1022 and on the intermediate dielectric structure 104. For example, the passivation/protection layer or layer stack 138 may be a passivation for an electroless plating restriction. The passivation/protection layer or layer stack 138 is omitted in a region over the contact material 1281 where load electrodes or contact pads of the semiconductor device 100 are placed.

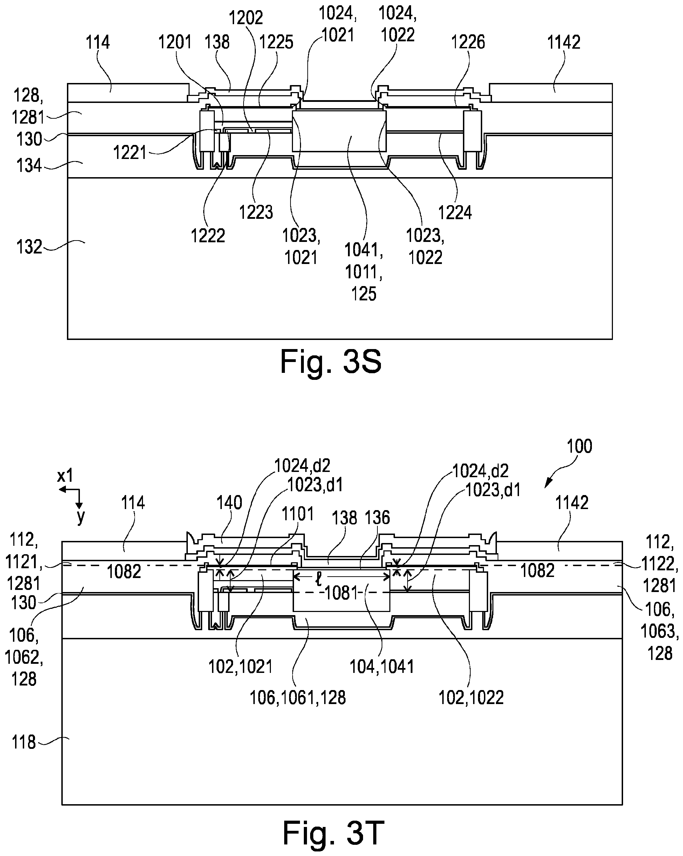

Referring to Fig. 3S, a first contact pad 114 is formed on the part of the contact material 1281 that is electrically connected to the first semiconductor substrate portion 1021. A second contact pad 1142 is formed on the part of the contact material 1281 that is electrically connected to the second semiconductor substrate portion 1022.

Referring to Fig. 3T, a passivation layer or layer stack 140 is formed on the passivation/protection layer or layer stack 138. A part of the contact material 1281 that is electrically connected to the first semiconductor substrate portion 1021 constitutes a first part 1121 of a patterned second metal layer 112. Another part of the contact material 1281 that is electrically connected to the second semiconductor substrate portion 1022 constitutes a second part 1122 of the patterned second metal layer 112. A part of the contact material 128 that electrically connects the first and second semiconductor substrate portions 1021, 1022 over the first surface 1081 constitutes a first part 1061 of a patterned first metal layer 106 over the first surface 1081. A part of the contact material 128 that is electrically connected to the first contact pad 114 constitutes a second part 1062 of the patterned first metal layer 106. A part of the contact material 128 that is electrically connected to the second contact pad 1142 constitutes a third part 1063 of the patterned first metal layer 106.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A semiconductor device (100), comprising:
a semiconductor substrate (102) including at least a first semiconductor substrate portion (1021) and a second semiconductor substrate portion (1022) separated from one another by a first part (1041) of an intermediate dielectric structure (104) along a first lateral direction (x1);
a patterned first metal layer (106) over a first surface (1081) of the semiconductor substrate (102), wherein a first part (1061) of the patterned first metal layer (106) electrically connects the first and second semiconductor substrate portions (1021, 1022) at the first surface (1081), and wherein
each of the first and second semiconductor substrate portions (1021, 1022) includes a main portion (1023) adjoining the first surface (1081) and an auxiliary portion (1024) adjoining a second surface (1082) opposite to the first surface (1081), and, with respect to each of the first and second semiconductor substrate portions (1021, 1022), a width (w12, w22) of the auxiliary portion (1024) along the first lateral direction (x1) is larger than a width (w11, w21) of the main portion (1023) along the first lateral direction (x1).

2. The semiconductor device (100) of the preceding claim, wherein, with respect to each of the first and second semiconductor substrate portions (1021, 1022), a thickness (d1) of the main portion (1023) along a vertical direction (y) is larger than a thickness (d2) of the auxiliary portion (1024) along the vertical direction (y).

3. The semiconductor device (100) of the preceding claim, wherein the thickness (d1) of the main portion (1023) of the first semiconductor substrate portion (1021) equals the thickness of the main portion (1023) of the second semiconductor substrate portion (1022), and the thickness (d2) of the auxiliary portion (1024) of the first semiconductor substrate portion (1021) equals the thickness (d2) of the auxiliary portion (1024) of the second semiconductor substrate portion (1022).

4. The semiconductor device (100) of any of the two preceding claims, wherein the thickness (d2) of the auxiliary portion (1024) ranges from 500 nm to 10 µm.

5. The semiconductor device (100) of any of the preceding claims, wherein a lateral distance (I) between the main portion (1023) of the first and second semiconductor substrate portions (1021, 1022) ranges from 5 µm to 500 µm.

6. The semiconductor device (100) of any of the preceding claims, wherein the auxiliary portion (1024) of the first semiconductor substrate portion (1021) includes a doped semiconductor contact region (1101) having a doping concentration larger than 1 × 10¹⁹ cm⁻³, and the semiconductor device (100) further includes a patterned second metal layer (112) over a second surface (1082) of the semiconductor substrate (102), wherein a first part (1121) of the patterned second metal layer (112) electrically connects the doped semiconductor contact region (1101) to a first contact pad (114), the first contact pad (114) being laterally spaced from the first semiconductor substrate portion (1021).

7. The semiconductor device (100) of the preceding claim, further comprising a passivation layer (138) extending from over the second surface (1082) of the first semiconductor substrate portion (1021) to over the second surface (1082) of the second semiconductor substrate portion (1022).

8. The semiconductor device (100) of any of the preceding claims, further comprising a carrier (132) mounted on the semiconductor substrate (102) at a side of the first surface (1081) of the semiconductor substrate (102).

9. The semiconductor device (100) of any of the preceding claims, wherein the semiconductor device (100) is an ESD protection device in a chip package including a first ESD protection sub-device in the first semiconductor substrate portion (1021) and a second ESD protection sub-device in the second semiconductor substrate portion (1022).

10. A method of manufacturing a semiconductor device (100), the method comprising:
forming a semiconductor substrate (102) including at least a first semiconductor substrate portion (1021) and a second semiconductor substrate portion (1022) separated from one another by a first part (1041) of an intermediate dielectric structure (104) along a first lateral direction (x1);
forming a patterned first metal layer (106) over a first surface (1081) of the semiconductor substrate (102), wherein a first part (1061) of the patterned first metal layer (106) electrically connects the first and second semiconductor substrate portions (1021, 1022) at the first surface (1081), and wherein
each of the first and second semiconductor substrate portions (1021, 1022) includes a main portion (1023) adjoining the first surface (1081) and an auxiliary portion (1024) adjoining a second surface (1082) opposite to the first surface (1081), and, with respect to each of the first and second semiconductor substrate portions (1021, 1022), a width (w12, w22) of the auxiliary portion (1024) along the first lateral direction (x1) is larger than a width (w11, w21) of the main portion (1023) along the first lateral direction (x1).

11. The method of the preceding claim, wherein forming the semiconductor substrate (102) includes processing the semiconductor substrate (102) at the first surface (1081) by at least one doping process; thereafter
conducting a first masked etch process at the first surface (1081) of the semiconductor substrate (102) for defining the main portion (1023) of the first semiconductor substrate portion (1021) and of the second semiconductor substrate portion (1022).

12. The method of the preceding claim, further comprising:
after conducting the first masked etch process, mounting a carrier (132) on the semiconductor substrate (102) at a side of the first surface (1081) of the semiconductor substrate (102); and
reducing a thickness of the semiconductor substrate (102) by machining and/or etching processes;
processing the semiconductor substrate (102) at the second surface (1082) by at least one doping process; and
conducting a second masked etch process at the second surface (1082) of the semiconductor substrate (102) for defining the auxiliary portion (1024) of the first semiconductor substrate portion (1021) and of the second semiconductor substrate portion (1022).

13. The method of the preceding claim, wherein processing the semiconductor substrate (102) at the second surface (1082) includes forming a doped semiconductor contact region (1101) having a doping concentration larger than 5 × 10¹⁹ cm⁻³ in the auxiliary portion (1024) of the first semiconductor substrate portion (1021), and wherein dopants of the semiconductor contact region (1101) are electrically activated by a laser thermal anneal, LTA process.

14. The semiconductor device (100) of any of the two preceding claims, further comprising:
forming a patterned second metal layer (112) over the second surface (1082) of the semiconductor substrate (102); and
forming a passivation layer (138, 140) on the patterned second metal layer (112) and on the intermediate dielectric structure (104), wherein the passivation layer (138, 140) extends from over the second surface (1082) of the first semiconductor substrate portion (1021) to over the second surface (1082) of the second semiconductor substrate portion (1022).
